# FASCICULE DE BREVET EUROPEEN

(11) **EP 4 386 326 B1**
(45) Date de publication et mention de la délivrance du brevet: **26.08.2026**
(21) Numéro de dépôt: 23217034.0
(22) Date de dépôt: 15.12.2023
(51) Int. Cl.: G01D 4/00

(54) **PROCÉDÉ ET SYSTEME DE SUPERVISION D'UNE CONSOMMATION ÉLECTRIQUE**
VERFAHREN UND SYSTEM ZUR ÜBERWACHUNG EINES ELEKTRISCHEN VERBRAUCHERS
METHOD AND SYSTEM FOR SUPERVISING POWER CONSUMPTION

(30) Priorité: 16.12.2022 FR 2213587
(43) Date de publication de la demande: 19.06.2024
(73) Titulaire: Sagemcom Energy & Telecom SAS, 92270 Bois-Colombes (FR)
(72) Inventeur: ABID, Oussama, 92270 BOIS-COLOMBES (FR); SABRAOUI, Abbas, 92270 BOIS-COLOMBES (FR); BASTURK, Ahmet Samed, 92270 BOIS-COLOMBES (FR)
(74) Mandataire: Regimbeau

(56) Documents cités:
- WO-A1-2021/110224
- US-A1- 2016 021 613
- US-A1- 2020 053 437
- JAMEEL QADRI ET AL: "A Review of Significance of Energy-Consumption Anomaly in Malware Detection in Mobile Devices", INTERNATIONAL JOURNAL ON CYBER SITUATIONAL AWARENESS, vol. 1, no. 1, 26 November 2016 (2016-11-26), pages 210 - 230, XP055748466, ISSN: 2057-2182, DOI: 10.22619/IJCSA.2016.1001010

## Description

### DOMAINE DE L'INVENTION

L'invention concerne un procédé et un système de supervision d'une consommation électrique d'un compteur communicant à pile. Plus spécifiquement, l'invention trouve application dans le domaine des compteurs de fluide (compteurs d'eau, compteurs de gaz, etc.).

### ETAT DE LA TECHNIQUE

Les compteurs communicants permettent de suivre dans le temps des données de consommation (eau, gaz, etc...) et de transmettre ces données, éventuellement en temps réel, à un gestionnaire du réseau de distribution à distance. Différentes fonctionnalités sont gérées par le (ou les) microprocesseur(s) du compteur (mesure, transmission et réception de données, calculs, affichage, etc....). L'ensemble des fonctionnalités du compteur génère une consommation électrique, ainsi qu'une valeur d'intensité de courant associée, qui peuvent varier au cours du temps. Dans un système communicant à pile, avec une durée de vie qui peut s'étaler sur plusieurs années, des anomalies de consommation électrique (surconsommations ou sous-consommations) - peuvent apparaître et avoir des causes multiples, telles que des changements des conditions de l'environnement du compteur (température, humidité, etc.) ; des anomalies dans le logiciel applicatif du compteur, qui peuvent être difficilement détectables ; ou une usure prématurée d'un ou plusieurs composants électroniques du compteur.

Un tel système de supervision d'une consommation électrique d'un compteur communicant à pile est connu du document WO2021/110224 A1.

Ces anomalies de consommation électrique peuvent avoir des conséquences sur la durée de vie de la pile. Il est donc souhaitable de pouvoir suivre la consommation électrique du compteur et de détecter et alerter de toute dérive ou incohérence de fonctionnement par rapport à un mode nominal.

De façon plus générale, il est souhaitable de pouvoir suivre le bon fonctionnement du logiciel embarqué tout au long de la durée de vie du compteur.

### EXPOSE DE L'INVENTION

Un but général de l'invention est de proposer une solution permettant de pallier les inconvénients des compteurs communicants de l'état de la technique.

A cet effet, on prévoit un procédé de supervision de la consommation électrique d'un compteur communicant à pile, comprenant une mesure relative au courant électrique consommé par ledit compteur,

Le procédé comprenant :
- une identification d'au moins une fonctionnalité mise en œuvre par le compteur par comparaison de données se rapportant à cette mesure mesurées avec des signatures mémorisées dans une base de données de signatures, chaque signature de ladite base étant représentative de la consommation du compteur lors de la mise en œuvre d'une fonctionnalité par ledit compteur dans un mode de fonctionnement nominal du compteur ;
- un suivi dans le temps de la séquence de fonctionnalités ainsi identifiées et la détection d'une éventuelle dérive par rapport à un fonctionnement nominal,
- une identification d'au moins une fonctionnalité mise en œuvre par le compteur responsable de la dérive.

Ainsi, le procédé de supervision selon l'invention permet d'identifier des sources responsables de l'anomalie de consommation électrique du compteur communicant constatée par rapport à un mode de fonctionnement normal, comprenant des fonctionnalités du compteur.

Le procédé permet également de superviser, de façon continue ou intermittente, le courant électrique consommé par les différents microcontrôleurs, modules radio et autres éléments qui composent le système contraint.

Le procédé permet également d'identifier et de monitorer les actions prises par des logiciels embarqués du compteur.

Le procédé permet également de réaliser une estimation d'une durée de vie restante de la pile suite à une anomalie constatée de consommation électrique du compteur.

Enfin, le procédé permet d'alerter un utilisateur de toute consommation anormale détectée par un système de supervision.

Selon une mise en œuvre du procédé, la détection d'une dérive génère l'émission d'un signal d'alerte et/ou des actions correctives.

Selon une mise en œuvre du procédé, une action corrective comprend un arrêt de la (ou des) fonctionnalité(s) ou une réduction d'une intensité de courant maximale allouée à cette (ou ces) fonctionnalité(s).

Selon une mise en œuvre du procédé, au moins une fonctionnalité donnée est maintenue y compris en cas de dérive, de sorte à garantir le maintien en fonctionnement du compteur.

Selon une mise en œuvre du procédé, comprenant en outre une estimation d'une durée de vie restante de la pile en fonction des données mesurées.

Selon une mise en œuvre du procédé, les fonctionnalités du compteur communicant comprenant une ou plusieurs fonctionnalités choisies parmi :
- des transmissions radio
- des opérations effectuées par un microcontrôleur
- des opérations de métrologie
- des transmission Bluetooth à basse consommation.

Selon une mise en œuvre du procédé, le procédé comprend en outre une détection d'une surconsommation électrique et/ou d'une sous-consommation électrique par le compteur communicant.

L'invention concerne en outre un produit programme d'ordinateur mettant en œuvre le procédé de supervision selon l'invention.

L'invention concerne en outre un système de supervision de la consommation électrique d'un compteur communicant, le système de supervision fonctionnant grâce à un logiciel applicatif distinct d'un logiciel applicatif du compteur, le système de supervision comprenant un microprocesseur adapté pour mettre en œuvre le procédé selon l'invention.

Enfin, l'invention concerne un compteur communicant à pile, comprenant un système de supervision selon l'invention.

### DESCRIPTION DES FIGURES

Nous allons maintenant présenter un mode de réalisation de l'invention à titre d'exemple non-limitatif à l'appui des dessins sur lesquels :
La figure 1 illustre de manière schématique un compteur communicant, comprenant un système de supervision selon l'invention.
La figure 2 illustre plusieurs signatures pouvant être comprises dans la base de données.
La figure 3 est un schéma fonctionnel du procédé de supervision proposé par l'invention, dans sa mise en œuvre la plus générale.
La figure 4 est un schéma fonctionnel illustrant la détection de signatures dans le cadre du procédé proposé.
La figure 5 est un schéma fonctionnel illustrant une mise en œuvre particulière du procédé de supervision.
La figure 6 est un schéma fonctionnel illustrant un procédé dynamique d'établissement d'une base de données de signatures.

### DESCRIPTION DÉTAILLÉE

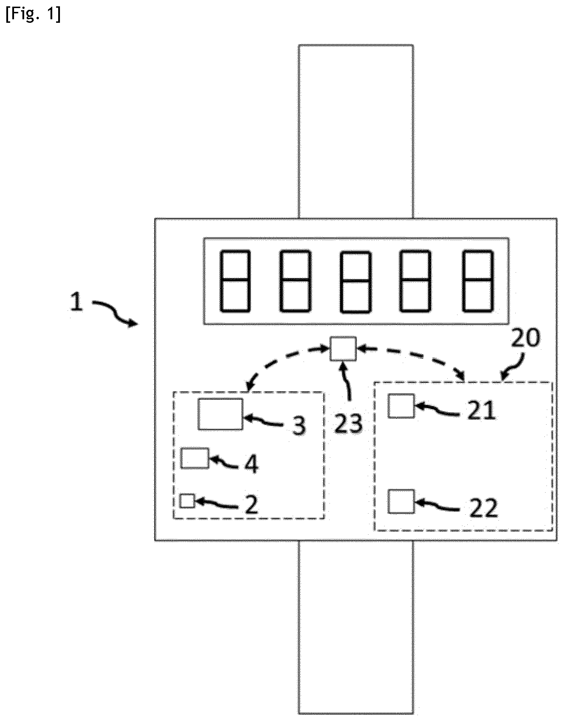

La figure 1 représente un compteur communicant 1. Un tel compteur comprend typiquement un microprocesseur 2, une pile 3 et des moyens de communication 4 avec un serveur distant. Il peut notamment s'agir d'un compteur d'eau ou de gaz. Ce compteur 1 est associé à une pluralité de fonctionnalités qui génèrent ensemble une consommation électrique globale du compteur. Par exemple, pour un compteur électrique, les fonctionnalités peuvent être l'émission d'un signal radio, la réalisation de mesures ou le fonctionnement d'un microcontrôleur.

Le procédé peut notamment être mis en œuvre par un système de supervision 20 du compteur 1, dont le système applicatif est distinct d'un système applicatif du compteur 1.

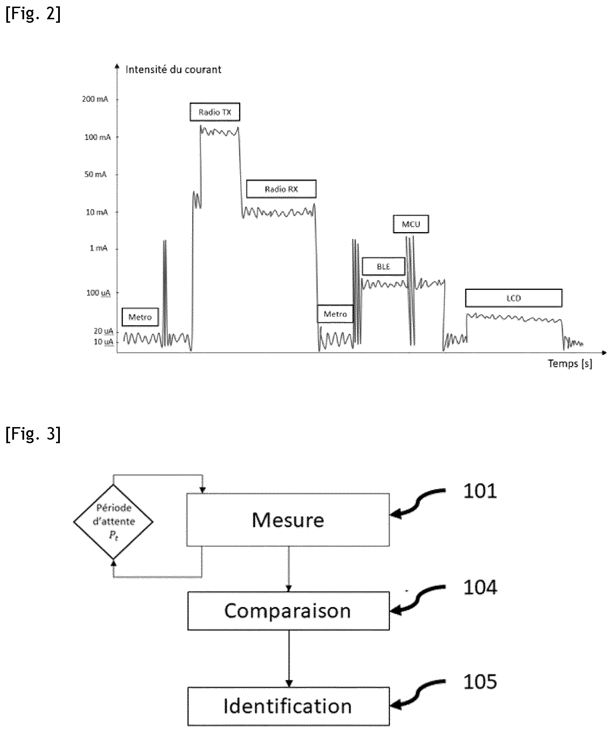

Lorsque chaque fonctionnalité est en mode de fonctionnement normal, elle consomme une certaine valeur d'intensité de courant qu'on peut caractériser par une signature, généralement par une valeur maximum et une valeur moyenne, et éventuellement une valeur minimum. La signature peut également comprendre d'autres données, telles que la fréquence ou la durée du signal : par exemple, et en référence à la figure 2, une transmission radio est identifiable par une intensité de l'ordre d'une dizaine de milliampères sur une durée allant de dix millisecondes à une dizaine de secondes, alors que des mesures sont identifiables par des pics de courant courts mais réguliers. Une dérive de la valeur d'intensité de courant consommé, c'est-à-dire une surconsommation ou une sous-consommation de courant par rapport à la valeur nominale attendue, indique généralement qu'une fonctionnalité n'est pas dans son mode normal de fonctionnement. Il peut par exemple s'agir d'une anomalie dans le logiciel pilotant la fonctionnalité, d'une surchauffe, ou de l'usure de certains composants électroniques que comporte la fonctionnalité. Toute consommation dont la signature est non reconnue et qui rajoute un palier d'intensité constant sur de longues périodes est assimilée à un problème impactant la pile 3 du compteur communicant 1.

Le procédé proposé est mis en œuvre grâce à l'utilisation d'une base de données afin d'identifier une ou des fonctionnalités parmi les fonctionnalités du compteur 1 qui sont responsables d'une telle anomalie de courant. Dans sa mise en œuvre la plus générale, et en référence à la figure 3, le procédé comprend une première étape 101 de mesure de données relatives à la consommation électrique du compteur 1. Ces données comprendront généralement la valeur d'intensité de courant consommée par le compteur, mais pourront comprendre d'autres valeurs connexes, telles que l'énergie ou la puissance consommée par une fonctionnalité, ou la variation d'intensité entre deux instants. On peut ainsi définir un instant initial *t₀* et final *t_{f}* de la mesure 101, et un pas de mesure *Δt* entre deux instants successifs de mesure. Le procédé comprend ensuite une étape 104 de comparaison des données mesurées avec des signatures comprises dans la base de données, qui permet ensuite une étape d'identification 105 d'une ou plusieurs signatures correspondant à des fonctionnalités responsables de l'anomalie de courant.

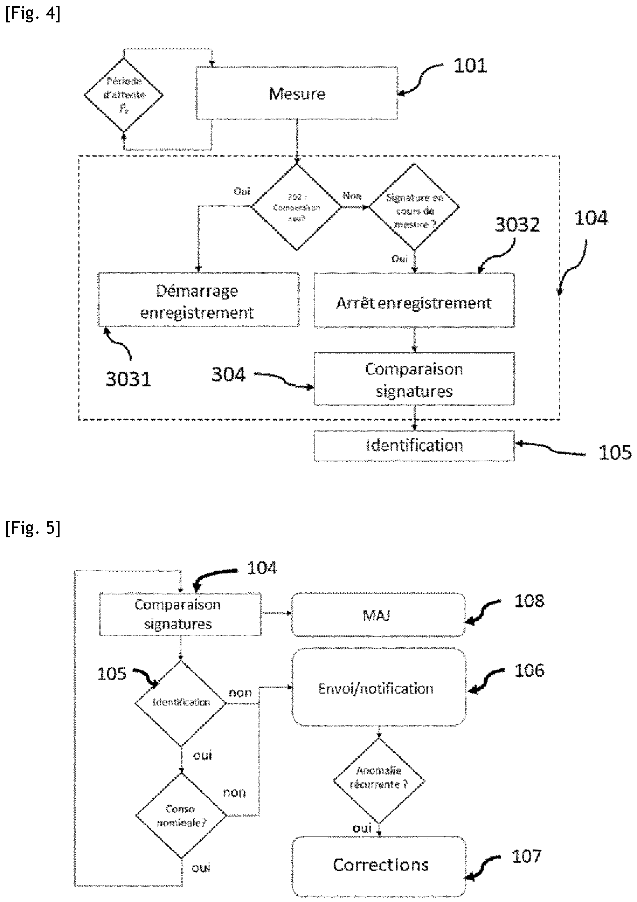

La figure 4 illustre des sous-étapes de détection de signatures de l'étape 104 de comparaison selon le procédé proposé. On commence par définir un seuil maximal S*ₘₐₓ*. L'étape 101 de mesure de données relatives au courant, notamment de mesures d'intensité réalisées à une pluralité d'instants, est suivie à chaque instant d'une étape 302 de comparaison entre chaque valeur d'intensité mesurée et ce seuil. Le seuil S*ₘₐₓ* est choisi pour être indicatif d'une surconsommation de courant lorsque la consommation globale du compteur 1 excède ce seuil. Dès qu'une valeur d'intensité mesurée dépasse le seuil S*ₘₐₓ*, on initie à l'étape 3031 un enregistrement 303 pour enregistrer, par exemple dans une mémoire du système de supervision 20, certaines données choisies parmi les données mesurées. On peut choisir d'enregistrer toutes les données mesurées pendant l'étape 301 de mesure, ou seulement certaines de ces données considérées comme plus importantes, de façon à ne pas surcharger la mémoire du système de supervision 20. Avantageusement, l'enregistrement 303 comprendra l'enregistrement d'un niveau maximal d'intensité consommée *Iₘₐₓ,* d'un niveau moyen d'intensité consommée *I_{avg}* et d'un niveau minimal d'intensité consommée *Iₘᵢₙ* sur la durée totale d'enregistrement. L'enregistrement ainsi obtenu pourra alors faire l'objet d'une comparaison 304 avec les signatures contenues dans la base de données. La comparaison 304 peut éventuellement être suivie d'une notification des résultats de la comparaison 304 au contrôleur 23 du système de supervision 20. On réalisera alors l'identification 105 des fonctionnalités 5 responsables de l'anomalie de consommation électrique du compteur communicant 1.

On met fin à l'enregistrement dans une étape 3032 dès lors qu'une valeur d'intensité mesurée est inférieure au seuil S*ₘₐₓ*, ce qui indique un retour à un mode de fonctionnement normal.

Éventuellement, le procédé peut n'initier l'enregistrement que lorsqu'une pluralité de valeurs d'intensité mesurées dépassent le seuil S*ₘₐₓ*, et/ou n'arrêter l'enregistrement 303 que lorsqu'une pluralité de valeurs d'intensité mesurées se trouvent en-deçà du seuil maximal *Sₘₐₓ*. Par une pluralité de valeurs, on entend soit un nombre prédéterminé de valeurs mesurées, soit plusieurs valeurs mesurées pendant un laps de temps prédéterminé. On évite ainsi un lancement et/ou un arrêt intempestif de l'enregistrement 303 à cause de valeurs mesurées aberrantes, non représentatives du signal que l'on cherche à identifier.

Il est également possible, de manière analogue, de définir un seuil minimal Sₘᵢₙ indicatif d'une sous-consommation globale de courant du compteur 1, soit à la place du seuil maximal S*ₘₐₓ*, soit de manière complémentaire à celui-ci.

Selon une mise en œuvre particulière, il est également possible de définir un seuil de bruit *S_{b}*, correspondant à une valeur d'intensité de courant au-dessous de laquelle une valeur mesurée n'est pas considérée par le procédé comme étant indicative d'un phénomène physique. En d'autres termes, le procédé ne prévoira aucune action sur la base de cette valeur mesurée, quand bien même celle-ci serait inférieure au seuil minimum *Sₘᵢₙ* défini précédemment. Ceci permet d'écarter les mesures qui correspondent à un bruit de fond et pas à un réel signal physique dû à une fonctionnalité 5 du compteur communicant 1.

Pour les sous-étapes de la comparaison 104, le système de supervision 20 définit une fenêtre glissante, dont la taille et la résolution dépendront des caractéristiques du système, notamment sa capacité de calcul, sa capacité de mémoire RAM, et/ou la taille maximale des signatures qu'il peut contenir. Par exemple, le tableau 1 illustre l'identification d'une signature de niveau d'intensité utilisée par le compteur, effectuée selon une pluralité d'instants. Le seuil Smax est fixé à 12 microampères, de sorte qu'on identifie une signature entre les instants *t*₋₁₅ et *t*₋₇.

| Instant | *t*_{-*n*} | .. | ... | *t*₋₁₅ | *t*₋₁₄ | *t*₋₁₃ | *t*₋₁₂ | *t*₋₁₁ | *t*₋₁₀ | *t*₋₉ | *t*₋₈ | *t*₋₇ | *t*₋₆ | *t*₋₄ | *t*₋₂ | *t*₋₁ | *t*₀ |
|---|---|---|---|---|---|---|---|---|---|---|---|---|---|---|---|---|---|
| Intensité mesurée (uA) | 10 | | | 12 | 16 | 1580 | 1202 | 1603 | 1258 | 48 | 16 | 12 | 10 | 10 | 11 | 12 | 10 |

Les fonctionnalités du compteur communicant 1 pourront comprendre, par exemple mais de manière non limitative, des transmissions radio, des opérations effectuées par un ou des microcontrôleurs, des opérations de métrologie et/ou des transmissions Bluetooth à basse consommation (en anglais « *Bluetooth low energy* » ou BLE).

Le procédé peut comprendre en outre une détection d'une dérive des données mesurées par rapport à un fonctionnement nominal attendu du compteur.

Selon un mode de réalisation, le compteur 1 comprend une interface 23 entre le système de supervision 20 et le reste du compteur 1, prévue pour échanger des données entre ceux-ci. Lorsque la comparaison 104 a permis l'identification 105 d'une ou plusieurs signatures de fonctionnalités du compteur 1 dans la valeur d'intensité consommée, les données enregistrées peuvent ainsi être envoyées lors d'une étape d'envoi 106 au système de supervision 20 de sorte à permettre leur post-traitement.

Éventuellement, on peut prévoir que l'étape d'envoi 106 comprenne l'envoi d'une notification lorsqu'une ou plusieurs signatures sont identifiées mais que la consommation n'est pas nominale comparée aux valeurs enregistrées dans la base de données, et notamment qu'une sous-consommation ou qu'une surconsommation a lieu. Par exemple, la base de données peut comprendre des signatures indiquant une intensité nominale consommée ainsi qu'une plage de valeurs d'intensités correspondant à la signature. Si les données enregistrées comprennent des valeurs d'intensité qui divergent de l'intensité nominale mais se trouvent dans la plage de valeurs ainsi définie, alors la signature est identifiée mais est considérée comme non nominale, et l'étape d'envoi 106 comprend alors une notification au système de supervision 20. Un signal non nominal mais correspondant à une signature connue aura donc typiquement une période comparable à celle du signal nominal correspondant, avec un changement de l'intensité moyenne. Ainsi, toute constatation d'une dérive des données mesurées par rapport au fonctionnement nominal attendu du compteur fait l'objet d'une notification au système de supervision, afin de l'alerter.

La figure 5 illustre une mise en œuvre particulière du procédé de supervision proposé. Cette mise en œuvre comprend la mise en place de corrections 107 visant à rétablir un fonctionnement normal du compteur 1, notamment pour modérer la réduction de durée de vie restante de la pile lors de surconsommations de courant. De telles corrections 107 peuvent comprendre une restriction des fonctionnalités identifiées comme responsables d'une anomalie de courant, notamment d'un dépassement de seuil. Il peut être avantageux de ne mettre en œuvre ces restrictions que lorsqu'une anomalie est constatée de manière récurrente, tel qu'établi suite à la constatation, à l'étape 104 de comparaison, d'une dérive de la consommation par rapport à une consommation nominale et à l'étape d'envoi 106 de données au système de supervision 20 via l'interface 23. Selon des critères prédéfinis, tels qu'une capacité restante de la source d'énergie du compteur 1, ou le caractère essentiel des fonctionnalités responsables de l'anomalie de courant, la restriction 107 pourra consister en l'arrêt total des fonctionnalités responsables, ou de manière plus modérée en une restriction de l'intensité de courant que celles-ci peuvent recevoir de la source d'énergie pour leur fonctionnement. Additionnellement ou alternativement, on pourra définir certaines fonctionnalités comme des fonctionnalités essentielles, pour lesquelles il est nécessaire d'allouer une certaine valeur d'intensité de courant. Si certaines de ces fonctionnalités essentielles font partie des fonctionnalités responsables pour une anomalie de courant, la restriction 107 pourra réduire le courant alloué à ces fonctionnalités essentielles, mais uniquement de sorte à leur permettre de fonctionner de manière satisfaisante. En revanche, si certaines des fonctionnalités responsables d'une anomalie ne font pas partie des fonctions essentielles, le courant qui leur est alloué peut-être réduit davantage, car une dégradation de leur fonctionnement, voire l'arrêt total de celui-ci est considéré comme admissible. En cas de surconsommation, on peut ainsi gérer le courant afin de prioriser les fonctionnalités considérées comme essentielles.

Les corrections 107 peuvent être mise en œuvre par une modification, éventuellement automatisée, de configuration d'un logiciel applicatif du compteur communicant 1.

Le procédé de supervision peut en outre comprendre un calcul 108 du niveau d'énergie restant *Cᵣₑₛₜₐₙₜ* dans la pile 3 du compteur 1 suite à la détection d'une anomalie de courant. Ce niveau d'énergie est calculé selon l'équation : ${C}_{restante \left(t\right)} = {C}_{restante \left(t-1\right)} - \left({Δ}_{t}∗{I}_{idle}\right) - \left({Δ}_{sig}∗{I}_{sig}\right)$ où Δt est le pas entre deux signatures détectées, *Δsig* la durée de la signature détectée, *I_{idle}* la consommation nominale moyenne du compteur 1 et *I_{sig}* l'intensité moyenne de la signature détectée, et *t* et *t-1* représentent respectivement des instants après et avant l'anomalie de courant. Ce calcul de niveau d'énergie restant permettra éventuellement de réaliser une estimation d'une durée de vie restante de la pile 3.

L'invention propose également un produit programme d'ordinateur mettant en œuvre le procédé de supervision décrit ci-avant.

Comme mentionné précédemment, le compteur communicant 1 selon l'invention comporte un système de supervision 20 permettant de mettre en œuvre le procédé proposé. Ce système 20 fonctionne grâce à un logiciel applicatif distinct de celui du compteur 1. Il comprend au moins un microprocesseur 22, qui peut être distinct d'un microprocesseur du compteur 1, ou fonctionner grâce à un même processeur multi-cœurs que le compteur 1 en utilisant un cœur distinct de celui utilisé par le compteur 1. Alternativement, le compteur 1 et le système de supervision 20 peuvent fonctionner grâce à un même microprocesseur 22 mettant en œuvre deux logiciels applicatifs distincts. Le système de supervision 2 comprend au moins un élément de détection 21 capable de détecter le flux de courant. Il peut notamment s'agir d'une résistance de faible valeur, de l'ordre du milliohm, placée dans le trajet du courant. La valeur du courant est déduite de la tension aux bornes du compteur 1 grâce à la loi d'Ohm.

Le fait de prévoir un système de supervision 20 fonctionnant grâce à un logiciel applicatif différent d'un logiciel applicatif du compteur 1 permet d'éviter la transmission d'un bug apparu dans l'un de ces deux logiciels au second.

La base de données comprenant les signatures utilisées par le procédé de supervision proposé peut être établie par une méthode statique ou une méthode dynamique. Le tableau 2 illustre des exemples de fonctionnalités, avec l'intensité minimum, moyenne et maximum associée, la durée du signal et la période, le cas échéant.

| **Fonctionnalité** | **Intensité** | | | **Durée** | **Période (si synchron e)** |
|---|---|---|---|---|---|
| | **Minimum** | **Moyenne** | **Maximum** | | |
| Métrologie | 2 uA | 5 uA | 10 uA | 10 ms | 125 ms |
| Radio | 10 mA | 60 mA | 120 mA | 200 ms | 1 par jour |
| Bouton | 1 mA | 1.2 mA | 1.6 mA | 200 ms | - |
| LCD | 235 uA | 250 uA | 255 uA | 60 sec | - |
| BLE | 5 mA | 6 mA | 7 mA | 20 sec | |
| Flash externe | 1.5 mA | 1.6 mA | 1.7 mA | 20 sec | 1 par jour |

La méthode statique consiste à injecter une base de données 10 de référence dans le logiciel embarqué du compteur 1, cette base étant établie préalablement à l'assemblage du compteur, par exemple par des mesures en laboratoires.

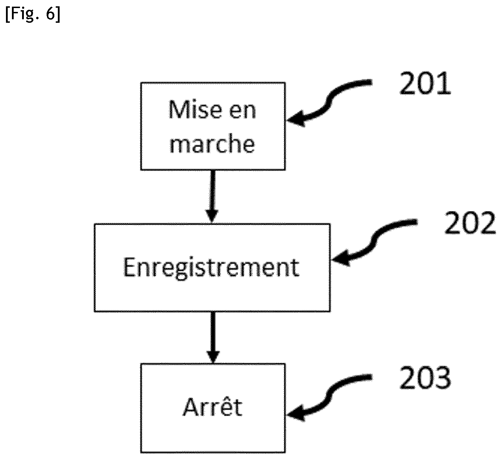

En référence à la figure 6, la méthode dynamique consiste à établir la base de données lors du fonctionnement du compteur. Cette méthode dynamique doit se faire en mode de fonctionnement nominal du compteur, c'est-à-dire lorsqu'il est établi qu'aucune anomalie de courant consommé n'est en train d'avoir lieu. Une fonctionnalité du compteur dont on souhaite obtenir la signature est mise en marche selon une étape 201. Puis, on initie un enregistrement 202 de données relatives au courant électrique consommé par la fonctionnalité, qui détermineront sa signature - par exemple mais de manière non limitative, une valeur d'intensité minimale *Iₘᵢₙ,* maximale *Iₘₐₓ* et/ou moyenne *I_{avg}*, une durée de signal, ou une fréquence. Lorsque la signature est obtenue, on met fin à l'enregistrement et on arrête la fonctionnalité dans une étape d'arrêt 203. Cette méthode dynamique présente l'avantage de permettre l'ajout de fonctionnalités ultérieurement à la fabrication du compteur 1, puis la caractérisation de leurs signatures afin de pouvoir mettre en œuvre le procédé de supervision proposé. On peut aussi mettre en œuvre cette méthode dynamique pendant une durée donnée pour une pluralité de fonctionnalités afin d'établir une base de données pour toutes ces fonctionnalités.

Lorsqu'on souhaite une supervision du compteur 1 à tout moment de son fonctionnement, le système de supervision 20 peut mettre en œuvre le procédé proposé de manière continue. Alternativement, et afin d'éviter la production de surconsommations par le système de supervision 20 lui-même, il est possible de mettre en œuvre le procédé de manière intermittente. Une première alternative est d'effectuer des mesures pendant une période donnée sur une plage de temps, par exemple mais non limitativement pendant dix secondes toutes les heures. Une deuxième alternative est de moduler le pas *Δt* de mesure. On peut éventuellement combiner ces deux alternatives en effectuant un échantillonnage d'un nombre donné de mesures pendant une période donnée sur une plage de temps. Une autre alternative, qui peut être effectuée séparément ou en combinaison avec les précédentes, est de synchroniser la mise en œuvre du procédé de supervision avec un évènement dont on sait qu'il a une influence sur la consommation globale du compteur 1, tel que le début d'une émission de signal radio.

Un fonctionnement intermittent du système de supervision 20 peut permettre de détecter certaines anomalies de courant, comme des dérives de consommation sporadiques, ou des surconsommations périodiques, tout en allongeant la durée de vie de la source d'énergie par rapport à une supervision continue.

Selon une mise en œuvre particulière, lorsqu'on souhaite davantage limiter la perte de durée de vie de la source d'énergie associée à l'utilisation du système 20 de supervision, il est possible d'affecter un pourcentage de la capacité de la source d'énergie, ou une intensité de courant maximale au système 20 de supervision. On peut par exemple, mais non limitativement, allouer 5% de la capacité totale de la pile 3 au fonctionnement du système de supervision 20, et ainsi s'assurer qu'aucune dérive ou anomalie de consommation ne passe inaperçue.

Typiquement, le dimensionnement du système de supervision 20 est effectué durant la fabrication du compteur, de sorte à respecter une telle limite de consommation quant à la capacité de la pile. Par exemple, mais non limitativement, on peut prévoir d'allouer un courant de cent microampères pour un système de supervision 20 fonctionnant continuellement, ou de vingt microampères par mesure pour un système de supervision effectuant des mesures discrètes.

## Revendications

1. Procédé de supervision de la consommation électrique d'un compteur communicant (1) à pile, comprenant une mesure (101) relative au courant électrique consommé par ledit compteur (1),
**caractérisé en ce qu'**il comprend :
- une identification d'au moins une fonctionnalité mise en œuvre par le compteur par comparaison (104) de données se rapportant à cette mesure mesurées avec des signatures mémorisées dans une base de données (10) de signatures, chaque signature de ladite base étant représentative de la consommation du compteur lors de la mise en œuvre d'une fonctionnalité par ledit compteur (1) dans un mode de fonctionnement nominal du compteur (1) ;
- un suivi dans le temps de la séquence de fonctionnalités ainsi identifiées et la détection d'une éventuelle dérive de consommation par rapport à une consommation nominale,
- une identification d'au moins une fonctionnalité mise en œuvre par le compteur responsable de la dérive de consommation.

2. Procédé selon la revendication 1, dans lequel la détection d'une dérive génère l'émission d'un signal d'alerte et/ou des actions correctives.

3. Procédé selon la revendication 2, dans lequel une action corrective (107) comprend un arrêt de la ou des fonctionnalité(s) responsables de la dérive ou une réduction d'une intensité de courant maximale allouée à cette (ou ces) fonctionnalité(s).

4. Procédé selon l'une des revendications 1 à 3, dans lequel au moins une fonctionnalité donnée est maintenue y compris en cas de dérive, de sorte à garantir le maintien en fonctionnement du compteur.

5. Procédé selon l'une des revendications 1 à 4, comprenant en outre une estimation (108) d'une durée de vie restante de la pile (3) en fonction des données mesurées.

6. Procédé selon l'une des revendications 1 à 5, les fonctionnalités du compteur communicant comprenant une ou plusieurs fonctionnalités choisies parmi :
- des transmissions radio
- des opérations effectuées par un microcontrôleur
- des opérations de métrologie
- des transmission Bluetooth à basse consommation

7. Procédé selon l'une des revendications 1 à 6, comprenant en outre une détection d'une surconsommation électrique et/ou d'une sous-consommation électrique par le compteur communicant (1).

8. Produit programme d'ordinateur mettant en œuvre le procédé de supervision selon l'une des revendications 1 à 7.

9. Système de supervision (20) de la consommation électrique d'un compteur communicant (1), le système de supervision (20) fonctionnant grâce à un logiciel applicatif distinct d'un logiciel applicatif du compteur (1), le système de supervision (20) comprenant un microprocesseur (22) adapté pour mettre en œuvre le procédé selon l'une quelconque des revendications 1 à 7.

10. Compteur communicant (1) à pile, comprenant un système de supervision (2) selon la revendication précédente.

## Patentansprüche

1. Verfahren zur Überwachung des Stromverbrauchs eines batteriebetriebenen kommunizierenden Zählers (1), das eine Messung (101) umfasst, die sich auf den von dem Zähler (1) verbrauchten elektrischen Strom bezieht,
**dadurch gekennzeichnet, dass** es umfasst:
- eine Identifizierung mindestens einer von dem Zähler durchgeführten Funktion durch Vergleich (104) von Daten, die sich auf diese Messung beziehen, mit in einer Signaturdatenbank (10) gespeicherten Signaturen, wobei jede Signatur in der Bank für den Verbrauch des Zählers bei der Durchführung einer Funktion durch den Zähler (1) in einem nominalen Betriebsmodus des Zählers (1) repräsentativ ist;
- eine zeitliche Überwachung einer so identifizierten Funktionssequenz und die Erkennung einer eventuellen Verbrauchsabweichung in Bezug auf einen nominalen Verbrauch,
- eine Identifizierung mindestens einer von dem Zähler durchgeführten Funktion, die für die Verbrauchsabweichung verantwortlich ist.

2. Verfahren nach Anspruch 1, wobei die Erkennung einer Abweichung die Ausgabe eines Warnsignals und/oder von Korrekturmaßnahmen auslöst.

3. Verfahren nach Anspruch 2, wobei eine Korrekturmaßnahme (107) ein Anhalten der für die Abweichung verantwortlichen Funktion/en oder eine Reduzierung einer dieser (oder diesen) Funktion/en zugeordneten maximalen Stromstärke umfasst.

4. Verfahren nach einem der Ansprüche 1 bis 3, wobei mindestens eine gegebene Funktion auch bei einer Abweichung erhalten bleibt, um den fortgesetzten Betrieb des Zählers zu gewährleisten.

5. Verfahren nach einem der Ansprüche 1 bis 4, das ferner eine Schätzung (108) einer verbleibenden Lebensdauer der Batterie (3) in Abhängigkeit von den gemessenen Daten umfasst.

6. Verfahren nach einem der Ansprüche 1 bis 5, wobei die Funktionen des kommunizierenden Zählers eine oder mehrere der folgenden Funktionen umfassen:
- Funkübertragungen
- Maßnahmen, die von einem Mikrocontroller durchgeführt werden
- metrologische Maßnahmen
- Bluetooth-Übertragungen mit niedrigem Verbrauch

7. Verfahren nach einem der Ansprüche 1 bis 6, das ferner die Erkennung eines Stromüberverbrauchs und/oder eines Stromunterverbrauchs durch den kommunizierenden Zähler (1) umfasst.

8. Computerprogrammprodukt, das das Verfahren nach einem der Ansprüche 1 bis 7 ausführt.

9. System zur Überwachung (20) des Stromverbrauchs eines kommunizierenden Zählers (1), wobei das Überwachungssystem (20) dank einer von der Anwendungssoftware des Zählers (1) verschiedenen Anwendungssoftware arbeitet, wobei das Überwachungssystem (20) einen Mikroprozessor (22) umfasst, der zur Durchführung des Verfahrens nach einem der Ansprüche 1 bis 7 geeignet ist.

10. Batteriebetriebener kommunizierende Zähler (1), der ein Überwachungssystem (2) nach vorhergehendem Anspruch umfasst.

## Claims

1. A method for supervising the electrical consumption of a battery-powered smart meter (1), comprising a measurement (101) relating to the electrical current consumed by said meter (1),
**characterized in that** it comprises:
- an identification of at least one functionality implemented by the meter by comparison (104) of data relating to this measurement that are measured with signatures stored in a signature database (10), each signature of said database being representative of the consumption of the meter during the implementation of a functionality by said meter (1) in a nominal operating mode of the meter (1);
- a monitoring over time of a sequence of functionalities thus identified and the detection of a possible drift relative to a nominal operation,
- an identification of at least one functionality implemented by the meter responsible for the drift.

2. The method according to claim 1, wherein the detection of a drift generates the emission of an alert signal and/or corrective actions.

3. The method according to claim 2, wherein a corrective action (107) comprises a stopping of the functionality/functionalities responsible for the drift or a reduction in a maximum current intensity allocated to this/these functionality/functionalities.

4. The method according to any of claims 1 to 3, wherein at least one given functionality is kept including in case of drift, so as to guarantee that the meter is kept in operation.

5. The method according to any of claims 1 to 4, further comprising an estimation (108) of a remaining service life of the battery (3) based on the measured data.

6. The method according to any of claims 1 to 5, the functionalities of the smart meter comprising one or several functionalities chosen among:
- radio transmissions
- operations performed by a microcontroller
- metrology operations
- low-consumption Bluetooth transmissions.

7. The method according to any of claims 1 to 6, further comprising a detection of electrical overconsumption and/or electrical underconsumption by the smart meter (1).

8. A computer program product implementing the supervision method according to any of claims 1 to 7.

9. A system (20) for supervising the electrical consumption of a smart meter (1), the supervision system (20) operating thanks to application software distinct from application software of the meter (1), the supervision system (20) comprising a microprocessor (22) adapted to implement the method according to any one of claims 1 to 7.

10. A battery-powered smart meter (1), comprising a supervision system (2) according to the preceding claim.
